Europäisches Patentamt

**European Patent Office**

**Office européen des brevets**

(19)

(11) Numéro de publication: **0 101 368**
**A2**

(12) # DEMANDE DE BREVET EUROPEEN

(21) Numéro de dépôt: **83401601.6**

(22) Date de dépôt: **02.08.83**

(51) Int. Cl.³: **H 01 L 33/00**

(30) Priorité: **10.08.82 FR 8213926**

(43) Date de publication de la demande:
**22.02.84 Bulletin 84/8**

(84) Etats contractants désignés:
**DE FR GB NL SE**

(71) Demandeur: **THOMSON-CSF**
**173, Boulevard Haussmann**
**F-75379 Paris Cedex 08(FR)**

(72) Inventeur: **Carballes, Jean-Claude**
**THOMSON-CSF SCPI 173, bld Haussmann**
**F-75379 Paris Cedex 08(FR)**

(72) Inventeur: **Mesquida, Guy**
**THOMSON-CSF SCPI 173, bld Haussmann**
**F-75379 Paris Cedex 08(FR)**

(74) Mandataire: **Taboureau, James et al,**
**THOMSON-CSF SCPI 173, Bld Haussmann**
**F-75379 Paris Cedex 08(FR)**

(54) **Association monolithique d'une diode électroluminescente et de lentilles.**

(57) Ensemble d'éléments de diodes électroluminescentes munis chacun d'une lentille et réalisés de façon mono-lithique.

Sur un substrat en GaAs(p) on fait croître une couche de GaAs(n), une première couche de confinement, une couche active, une deuxième couche de confinement et une couche de contact. L'émission est localisée ($E_1$, $E_2$, $E_3$, $E_4$, $E_5$, $E_6$, $E_7$) et des lentilles ($L_1$, $L_2$, $L_3$, $L_4$, $L_5$, $L_6$, $L_7$) sont réalisées par usinage ionique. Une métallisation (16) permet le contact pour tous les éléments.

Application aux télécommunication par fibres.

FIG.2

EP 0 101 368 A2

Croydon Printing Company Ltd.

# ASSOCIATION MONOLITHIQUE D'UNE DIODE ELECTROLUMINESCENTE ET DE LENTILLES.

La présente invention se rapporte aux diodes électroluminescentes ayant une optique monolithique de sortie du type hémisphérique.

La puissance optique fournie par ces diodes électroluminescentes est généralement couplée dans une fibre optique, qui propage des signaux optiques. Il est connu ainsi de coupler une puissance optique de 200 μW à une fibre optique de grande ouverture numérique, ayant un diamètre de 200 μm. On obtient ainsi une bande passante de l'ordre de 50 MHz pour les signaux propagés.

Pour ces diodes électroluminescentes il y a avantage à réaliser une lentille de sortie, pour réduire les pertes par réflexion totale se produisant à l'interface semiconducteur-air. Il est connu de rapporter une lentille, mais cette technique est délicate.

On prend généralement une lentille de type hémisphérique de rayon R et le rendement d'une telle lentille est bonne à condition de se limiter à une zone émissive de dimension linéaire $D_i$ inférieure à R/2, placée à une certaine distance optimale d de la lentille.

La présente invention à l'avantage par rapport à l'Art Antérieur de permettre, grâce à une localisation des couches actives émettrices, de réaliser les lentilles par une méthode d'intégration. De plus l'invention permet de placer les couches actives à la distance optimale des lentilles.

Brièvement c'est une diode électroluminescente comprenant, un substrat semiconducteur, une première couche de confinement, une couche active, une deuxième couche de confinement, une couche de contact sur laquelle est déposée une couche métallique caractérisée par le fait que des moyens permettant de localiser N zones émettrices de diamètre $D_i$ sur la couche active, qu'à chacune des ces zones est associée une lentille de type hémisphérique et que ces lentilles sont réalisées dans la couche de contact.

D'autres caractéristiques et avantages ressortiront de la description qui va suivre, illustrée par les figures qui représentent:

- figure 1, une vue schématique d'un élément, comprenant une zone émettrice et une lentille ;

- figure 2, une vue d'ensemble des éléments composant la diode électroluminescente.

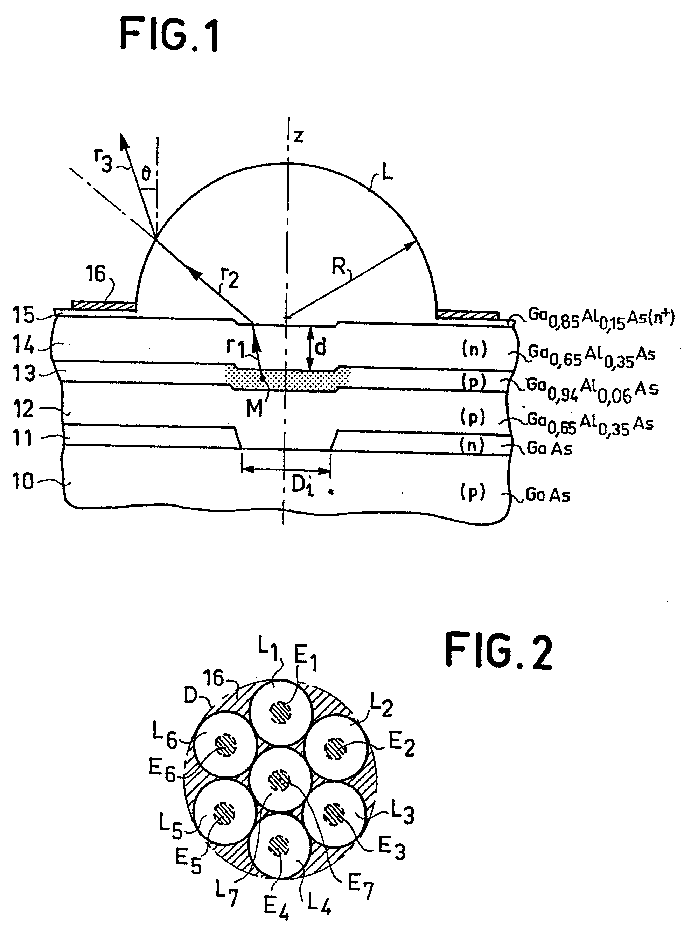

La figure 1 montre un élément de la diode électroluminescente muni d'une lentille L, suivant l'invention, réalisée à titre d'exemple sur un substrat 10, en GaAs(p). Sur le substrat on fait croître par épitaxie une couche de dopage inverse 11, en GaAs(n) comportant une ouverture centrale de diamètre $D_i$. Une première couche de confinement 12 est placée sur la couche de dopage inverse 11 et se trouve au contact du substrat 10, dans l'ouverture centrale.

Sur cette première couche de confinement 12 on fait croître successivement : la couche active 13, la deuxième couche de confinement 14 et finalement une couche de contact 15 qui est métallisée sur les bords 16.

Pour l'exemple choisi les formules pour les couches sont les suivantes :
1) $1^{\text{ère}}$ couche de confinement : $Ga_{0,65} As_{0,35}As(p)$
2) couche active $Ga_{0,94} Al_{0,06} As(p)$
3) $2^{e}$ couche de confinement : $Ga_{0,65} Al_{0,35}As(n)$
4) couche de contact : $Ga_{0,85} Al_{0,15} As(n)$.
Pour un substrat InP (n) la couche 11 sera du type InP (p).

La lentille du type hémisphérique de rayon R est réalisée directement dans la couche de contact. La couche active 13 émet dans une portion circulaire de diamètre $D_i$, limitée par la couche de dopage inverse 11.

Les épaisseurs des couches sont choisies pour que la valeur de la distance d de la couche active à la lentille ait une valeur prédéterminée.

Cette valeur dépend des valeurs de $D_i$, de R, de l'ouverture numérique et du diamètre de la fibre, dans laquelle on couple la lumière. Ce choix de la distance d permet l'optimisation de la directivité du faisceau lumineux, issu de la demi-sphère.

Sur la figure on a placé un rayon $r_1$ issu d'un point de la couche active 13, qui après réfraction se propage en $r_2$ dans la lentille et sort de la lentille suivant $r_3$, faisant un angle $\theta$ avec la normale z aux couches.

Pour obtenir une lentille par usinage ionique on prend $R < 50 \mu$ m. Pour couvrir une fibre ayant un diamètre de l'ordre de 100 m, on réalise de façon monolithique l'ensemble de microlentilles montrée par la figure 2.

Cette ensemble peut comporter à titre d'exemple 7 lentilles : $L_1$, $L_2$,

$L_3$, $L_4$, $L_5$, $L_6$ et $L_7$. On a figuré schématiquement les zones actives $E_1$, $E_2$, $E_3$, $E_4$, $E_5$, $E_6$ et $E_7$. Le cercle circonscrit D délimite la surface émissive effective. La zone 16 montre la couche métallique. Cet ensemble de la figure 2 est réalisé de façon monolithique. A titre d'exemple, la réalisation de la diode électroluminescente est obtenue par les opérations suivantes :

Sur le subtrat 10 on fait croître la couche de dopage inverse, suivi de la réalisation d'une ouverture par photolithographie ou d'une implantation de dopage localisée sur le diamètre $D_i$. Dans ce dernier cas on prend un substrat GaAs ($p^+$). Après croissance par épitaxie des couches successives, on réalise sur la couche de contact 15 par photolithographie et usinage ionique, des différentes lentilles $L_1$, $L_2$, $L_3$, $L_4$, $L_5$, $L_6$ et $L_7$.

En conclusion on a décrit une diode électroluminescente à haut rendement lumineux comportant un certain nombre d'éléments émetteurs, munis chacun d'une microlentille, l'ensemble étant réalisé de façon monolithique.

## REVENDICATIONS

1. Diode électroluminescente comprenant, supportées par un substrat (10), une couche de localisation (11) dont le dopage est inverse de celui du substrat (10), une couche optiquement active (13) comprise entre deux couches de confinement (12, 14), et une couche de contact (15) sur laquelle une première métallisation (16) assure un contact électrique, cette diode électroluminescente étant caractérisée en ce qu'elle comporte au moins une zone émettrice de lumière dans la couche active (13), cette zone étant localisée par l'intermédiaire d'une ouverture pratiquée dans la couche de localisation (11), ladite zone émettrice étant associée à au moins une lentille (L), réalisée directement dans la couche de contact (15) par usinage de cette couche.

2. Diode électroluminescente selon la revendication 1, caractérisée en ce que, une pluralité de zones émettrices de lumière $(E_1$ à $E_7)$ étant associée à une pluralité de lentilles $(L_1$ à $L_7)$, en vue du couplage avec une fibre optique, les zones émettrices $(E_1$ à $E_7)$ sont définies dans l'unique couche active (13) de façon que les lentilles $(L_1$ à $L_7)$, dans la couche de contact (15) soient tangentes entre elles.

3. Diode électroluminescente selon la revendication 1, caractérisée en ce que, le rayon (R) de la lentille (L) dans la couche de contact (15) étant supérieur au diamètre $(D_i)$ de la zone émettrice de lumière, l'épaisseur (d) de la couche de confinement (14) en contact avec la lentille (L) est choisie pour optimiser la directivité du faisceau lumineux sortant de la lentille (L).

4. Diode électroluminescente selon la revendication 1, caractérisée en ce que la lentille (L) usinée dans la couche de contact (15) est hémisphérique.

5. Diode électroluminescente selon la revendication 1, caractérisée en ce que le substrat (10) et la couche de localisation (11) sont en GaAs, de dopages opposés, et en ce que les couches de confinement (12, 14), la couche active (13) et la couche de contact (15) sont en GaAs partiellement substitué à l'aluminium.

6. Diode électroluminescente selon la revendication 1, caractérisée en ce que le substrat (10) et la couche de localisation (11) sont en InP, de dopages opposés.

7. Diode électroluminescente selon la revendication 1, caractérisée en ce que la lentille (L) est obtenue par photolithographie et usinage ionique dans la couche de contact (15) épaissé d'une diode monolithique.

# FIG.1

# FIG.2